(19) Europäisches Patentamt
European Patent Office
Office européen des brevets

(11) EP 0 892 941 B1

(12) **EUROPEAN PATENT SPECIFICATION**

(45) Date of publication and mention of the grant of the patent:
**08.08.2001 Bulletin 2001/32**

(21) Application number: **97915748.4**

(22) Date of filing: **09.04.1997**

(51) Int Cl.$^7$: **G03C 9/08**, G03F 7/029

(86) International application number:
**PCT/NL97/00177**

(87) International publication number:
**WO 97/38354 (16.10.1997 Gazette 1997/44)**

# (54) PHOTO-CURABLE RESIN COMPOSITION

PHOTOHÄRTBARE HARZZUSAMMENSETZUNG

COMPOSITION DE RESINE PHOTODURCISSABLE

(84) Designated Contracting States:
**CH DE FR GB IT LI NL**

(30) Priority: **09.04.1996 JP 8662696**

(43) Date of publication of application:
**27.01.1999 Bulletin 1999/04**

(73) Proprietors:
- **DSM N.V.**
  **6411 TE Heerlen (NL)**
- **JSR Corporation**
  **Tokyo 104-0045 (JP)**
- **Japan Fine Coatings Co., Ltd.**
  **Tokyo 104-8410 (JP)**

(72) Inventors:
- **WATANABE, Tsuyoshi**
  **Tsukuba City, Ibakari 305 (JP)**
- **MATSUMURA, Ayao**
  **Chuo-ku, Tokyo 104 (JP)**
- **HARUTA, Yuichi**
  **Chuo-ku, Tokyo 10 4 (JP)**
- **UKACHI, Takashi**
  **Ibaraki 300-12 (JP)**

(74) Representative: **den Hartog, Jeroen H.J. et al**
**DSM Patents & Trademarks**
**Office Geleen**
**P.O. Box 9**
**6160 MA Geleen (NL)**

(56) References cited:
**EP-A- 0 535 828** **EP-A- 0 605 361**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 892 941 B1

## Description

BACKGROUND OF THE INVENTION

Field of the Invention

The present invention relates to a photo-curable resin composition, especially to a liquid photo-curable resin composition suitable as material used in photo-fabrication processes.

Description of the Background Art

In recent years, photo-fabrication processes for forming three-dimensional objects consisting of integrally laminated cured resin layers prepared by repeating a step of forming a cured resin layer by selectively irradiating a liquid photo-curable material with light have been proposed (see Japanese Patent Application Laid-open No. 247515/1985, USP No. 4,575,330 (Japanese Patent Application Laid-open No. 35966/1987), Japanese Patent Application Laid-open No. 101408/1987, Japanese Patent Application Laid-open No. 24119/1993).

A typical example of such a photo-fabrication process comprises forming a curable resin layer having a specified pattern by selectively irradiating with light using, for example, an ultraviolet radiation laser on the surface of a liquid photo-curable material (photo-curable resin composition), feeding the photo-curable resin composition equivalent to one layer to form another thin layer of the composition over this cured resin layer, and selectively irradiating this thin layer with light to form a new cured resin layer which is integrally laminated over the previously formed cured resin layer. This step is repeated a number of times, with or without changing the pattern in which the light is irradiated to form a three-dimensional object consisting of integrally laminated multiple cured resin layers. This photo-fabrication process has been attracting considerable attention, because the target three-dimensional object can easily be prepared in a short period of time even if it has a complicated shape.

The following resin compositions (A) to (D) are reported as the photo-curable resin composition used in the photo-fabrication process.

(A) Resin compositions containing a radical polymerizable organic compound such as urethane(meth)acrylate, oligoester(meth)acrylate, epoxy(meth)acrylate, thiol-ene compounds, photosensitive polyimide, and the like (see Japanese Patent Applications Laid-open No. 204915/1989, No. 208305/1990, and No. 160013/1991).

(B) Resin compositions containing a cationic polymerizable organic compound such as an epoxy compound, cyclic ether compound, cyclic lactone compound, cyclic acetal compound, cyclic thioether compound, spiro-orthoester compound, vinylether compound, and the like (see Japanese Patent Application Laid-open No. 213304/1989).

(C) Resin compositions containing a radical polymerizable organic compound and a cationic polymerizable organic compound (see Japanese Patent Applications Laid-open No. 28261/1990, and No. 75618/1990).

(D) Resin compositions containing a radical polymerizable organic compound, a cationic polymerizable organic compound, and at least one trifunctional, OH-terminated polycaprolactone. (see Japanese Patent Application Laid-open No. 228413/1994).

The characteristics required of the photo-curable resin composition used for these photo-fabrication processes include a low viscosity to form a smooth liquid level and the capability of being rapidly cured by irradiation of light. Also, the required characteristics of the photo-curable resin composition are minimal swelling of the cured products and minimal deformation due to shrinkage during curing with light, such as production of warped parts, indented parts (sinkmark), or stretched parts (overhanging parts).

Three-dimensional objects prepared by photo-fabrication methods have conventionally been used for design model and trial mechanical parts. High dimensional accordance with the design model in fine processing, mechanical strength and heat resistance sufficient to withstand conditions of use are especially demanded of these trial mechanical parts. However, no conventional resin composition can satisfy the above demands. The three-dimensional objects obtained exhibit problems of deformation with the passage of time, such as production of warped parts, or indented parts, or stretched parts (overhanging parts), because of residual strain due to the shrinkage during curing. These problems of deformation with the passage of time can be partly solved by the correction of the input data to the CAD. However, the correction is insufficient to correspond to recent progress in fineness and complication in shape, and to circumstantial variations of use.

Mechanical characteristics of three-dimensional objects prepared by photo-fabrication by using conventional resin compositions containing an epoxy compound are degraded in the course of time in accordance with environmental conditions such as temperature and humidity. Therefore, use of these three-dimensional objects is unsuitable for the application requiring mechanical strength over an extended period of time.

Also, no three-dimensional object prepared by using conventional resin compositions is provided with mechanical strength, dimensional accuracy, heat resistance, and the like.

The present invention has been achieved in view of this situation and has an object of providing a novel photo-curable resin composition.

Another object of the present invention is to provide a photo-curable resin composition providing three-dimensional objects which have mechanical strength and high dimensional accuracy and which is suitable for trial mechanical parts.

Further object of the present invention is to provide a photo-curable resin composition which can be fabricated to produce a three-dimensional object provided with lasting minimal deformation characteristics.

A still further object of the present invention is to provide a photo-curable resin composition which can be fabricated to produce a three-dimensional object provided with lasting minimal degradation in mechanical characteristics.

## SUMMARY OF THE INVENTION

The above first object can be attained in the present invention by a photo-curable resin composition comprising,

(A) a cationic polymerizable organic compound,
(B) a cationic photo-initiator,
(C) an ethylenically unsaturated monomer,
(D) a radical photo-initiator, and
(E) a polyether polyol having three or more hydroxyl groups, wherein at least 60% by weight, relative to the total composition, of the said ethylenically unsaturated monomer (C) is a polyfunctional monomer having three or more ethylenically unsaturated bonds in one molecule.

## DETAILED DESCRIPTION OF THE INVENTION AND PREFERRED EMBODIMENTS

The present invention will now be explained in detail.

### <Cationic polymerizable organic compound>

The cationic polymerizable organic compound (hereinafter called [component (A)] ) contained in the photo-curable resin composition of the present invention is an organic compound which can polymerize or crosslink by photo-irradiation by irradiating light in the presence of a cationic photoinitiator. Typical examples of the component (A) are epoxy compounds, oxetane compounds, oxolane compounds, cyclic acetal compounds, cyclic lactone compounds, thiirane compounds, thietane compounds, vinylether compounds, spiro-ortho ester compounds which are reaction products of an epoxy compound and lactone, ethylenically unsaturated compounds, cyclic ether compounds, cyclic thioether compounds, and vinyl compounds.

For example, the following compounds can be illustrated as the epoxy compound which can be used as the component (A): bisphenol A diglycidyl ether, bisphenol F diglycidyl ether, bisphenol S diglycidyl ether, brominated bisphenol A diglycidyl ether, brominated bisphenol F diglycidyl ether, brominated bisphenol S diglycidyl ether, an epoxy novolac resin, hydrogenated bisphenol A diglycidyl ether, hydrogenated bisphenol F diglycidyl ether, hydrogenated bisphenol S diglycidyl ether, 3,4-epoxycyclohexylmethyl-3',4'-epoxy-cyclohexane carboxylate, 2-(3,4-epoxycyclohexyl-5,5-spiro-3,4-epoxy)cyclohexane-metha-dioxane, bis(3,4-epoxy-cyclohexylmethyl)adipate, vinylcyclohexene oxide, 4-vinyl epoxycyclohexane, bis(3,4-epoxy-6-methylcyclohexylmethyl) adipate, 3,4-epoxy-6-methyl cyclohexyl-3',4'-epoxy-6'-methyl-cyclohexane carboxylate, methylenebis(3,4-epoxycyclohexane), dicyclopentadiene diepoxide, di (3,4-epoxy-cyclohexylmethyl) ether of ethylene glycol, ethylene- bis(3,4-epoxycyclohexanecarboxylate), epoxyhexahydrodioctyl phthalate, di-2-ethylhexyl epoxyhexahydrophthalate, 1,4-butanediol diglycidyl ether, 1,6-hexanediol diglycidyl ether, glycerol triglycidyl ether, trimethylolpropane triglycidyl ether, polyethylene glycol diglycidyl ether, polypropylene glycol diglycidyl ethers; polyglycidyl ethers of polyether polyol obtained by adding one or more of alkylene oxide to aliphatic polyhydric alcohol such as ethylene glycol, propylene glycol, or glycerol; diglycidyl esters of aliphatic long chain dibasic acid; mono glycidyl ethers of aliphatic higher alcohol; mono glycidyl ethers of phenol, cresol, butyl phenol, or polyether alcohol obtained by addition of alkylene oxide to phenol, cresol, or butyl phenol; glycidyl esters of higher fatty acid; epoxidated soybean oil, butyl epoxystearate, octyl epoxystearate, epoxidated linseed oil, and epoxidated polybutadiene. Other compounds which can be used as the component (A) are oxetanes such as trimethylene oxide, 3,3-dimethyl oxetane, 3,3-dichloromethyl oxetane, 3-ethyl-3-phenoxymethyl oxetane, and bis(3-ethyl-3-methyloxy) butane; oxolane such as tetrahydrofuran and 2,3-dimethyltetrahydrofuran; cyclic acetals such as-trioxane, 1,3-dioxolane,

and 1,3,6-trioxan cyclooctane; cyclic lactones such as β-propiolactone and ε-caprolactone; thiirane such as ethylene sulfide, 1,2-propylene sulfide, and thioepychlorohydrin; thiethanes such as 3,3-dimethyl thiethane; vinyl ethers such as ethylene glycol divinyl ether, triethylene glycol divinyl ether, and trimethylolpropane trivinyl ether; spiro-ortho esters which are obtained by a reaction of epoxy compound and lactone; ethylenically unsaturated compounds such as vinyl cyclohexane, isobutylene, and polybutadiene; and their derivatives.

Among these cationic polymerizable compounds, desirable compounds are bisphenol A diglycidyl ether, bisphenol F diglycidyl ether, hydrogenated bisphenol A diglycidyl ether, hydrogenated bisphenol F diglycidyl ether, 3,4-epoxy-cyclohexylmethyl-3'4'-epoxycyclohexane carboxylate, bis-(3,4-epoxycyclohexylmethyl) adipate, 1,4-butanediol diglycidyl ether, 1,6-hexanediol diglycidyl ether, glycerol triglycidyl ether, trimethylolpropane triglycidyl ether, polyethylene glycol diglycidyl ether, and polypropylene glycol diglycidyl ether.

Particularly preferred cationic polymerizable compounds as the component (A) are the compounds possessing two or more alicyclic epoxy groups in a molecule, such as 3,4-epoxycyclohexylmethyl-3'4'-epoxycyclohexane carboxylate or bis- (3,4-epoxycyclohexylmethyl) adipate. When this type of epoxy compounds are contained in an amount of 50% by weight or more in the component (A), the resulting resin composition has a large cationic polymerization rate (curing rate), so that not only the molding time can be reduced, but also curing shrinkage can be decreased. This ensures three dimensional objects exhibiting only small deformation over time.

The following commercially available products are desirable as the cationic plymerizable organic compound used as the component (A): UVR-6100, UVR-6105, UVR-6110, UVR-6128, UVR-6200, UVR-6216 (manufactured by Union Carbide Corp), Celoxide 2021, Celoxide 2021P, Celoxide 2081, Celoxide 2083, Celoxide 2085, Celoxide 2000, Celoxide 3000, Glycidole, AOEX24, Cyclomer A200, Cyclomer M100, Epolead GT-300, Epolead GT-301, Epolead GT-302, Epolead GT-400, Epolead 401, Epolead 403 (manufactured by Daicel Chemical Industries Co., Ltd.), Epicoat 828, Epicoat 812, Epicoat 1031, Epicoat 872, Epicoat CT508 (manufactured by Yuka Shell Co., Ltd.), KRM-2100, KRM-2110, KRM-2199, KRM-2400, KRM-2410, KRM-2408, KRM-2490, KRM-2200, KRM-2720, KRM-2750 (manufactured by Asahi Denka Kogyo Co., Ltd.), Rapi-Cure DVE-3, CHVE, PEPC (manufactured by ISP Co., Ltd.), and VECTOMER 2010, 2020, 4010, 4020 (manufactured by Allied Signal Corp.).

The above cationic polymerizable compounds may be used either individually or in combinations of two or more.

The proportion of the component (A) in the photo-curable resin composition of the present invention is 30-85% by weight, preferably 40-80% by weight, and more preferably 50-75% by weight. If the proportion of the component (A) is too low, the dimensional accuracy of the three-dimensional object from the resin composition is decreased and the three-dimensional object tends to deform with time. On the other hand, if the proportion of the component (A) is too high, the photo-curing characteristic of the resulting resin composition is decreased, leading to a reduction in the fabricating efficiency.

<Cationic photo-initiator>

The cationic photo-initiator (hereinafter called [component (B)]) contained in the photo-curable resin composition of the present invention is a compound capable of generating a molecule initiating-cationic polymerization of the component (A) by receiving radiation such as light. Given as especially preferred examples of the cationic photo-initiator are onium salts illustrated by the following formula, which are compounds releasing Lewis acid on receiving light:

$$[R^1{}_aR^2{}_bR^3{}_cR^4{}_dZ]^{+m}[MX_{n+m}]^{-m}$$

wherein the cation is onium; Z represents S, Se, Te, P, As, Sb, Bi, O, I, Br, Cl, or N≡N; $R^1$, $R^2$, $R^3$, and $R^4$ represent individually the same or a different organic group; a, b, c, and d represent individually an integer from 0 to 3, and the summarized number of a, b, c, and d (=a+b+c+d) is equal to the valence number of Z. M represents a metal or metalloid which constitutes a center atom of a halide complex. Typical eamples of M are B, P, As, Sb, Fe, Sn, Bi, Al, Ca, In, Ti, Zn, Sc, V, Cr, Mn, and Co. X represents a halogen atom. m is a substantial electric charge and n is the number of atoms in the halide complex ion.

Given as specific examples of the negative ion ($MX_{n+m}$) in the above formula (1) are tetrafluoroborate ($BF_4^-$), hexafluorophosphate ($PF_6^-$), hexafluoroantimonate ($SbF_6^-$), hexafluoroarsenate ($AsF_6^-$), and hexachloroantimonate ($SbCl_6^-$).

Also, onium salts represented by the general formula [$MX_n(OH)$] can be used. Further, onium salts including a negative ion, for example, perchloric acid ion ($ClO_4^-$), trifluoromethane sulfonate ion ($CF_3SO_3^-$), fluorosulfonate ion ($FSO_3^-$), toluene sulfonate ion, trinitrobenzene sulfonate negative ion, and trinitrotoluene sulfonate negative ion are suitable.

Among these onium salts, especially effective onium salts are aromatic onium salts, in which the following

compounds are preferable: aromatic halonium salts described, for example, in Japanese Patent Applications Laid-open No. 151996/1975 and No. 158680/1975; VIA aromatic onium salts described, for example, in Japanese Patent Applications Laid-open No. 151997/1975, 30899/1977, No. 55420/1981, and No. 125105/1980; VA aromatic onium salts described, for example, in Japanese Patent Application Laid-open No. 158698/1975; oxosulfoxonium salts described, for example, in Japanese Patent Applications Laid-open No. 8428/1981, No. 149402/1981, and No. 192429/1982; aromatic diazonium salts described, for example, in Japanese Patent Application Laid-open No. 17040/1974; and thiobililium salts described in the specification of USP No. 4,139,655. Iron/allene complex and aluminium complex/photo-decomposed silica compound initiator are also given as examples of the onium salts.

Given as preferred examples of commercially available products of the cationic photo-initiator which can be used as the component (B) are UVI-6950, UVI-6970, UVI-6974, UVI-6990 (manufactured by Union Carbide Corp), Adekaoptomer SP-150, SP-151, SP-170, SP-171 (manufactured by Asahi Denka Kogyo Co., Ltd.), Irgacure 261 (manufactured by Ciba Geigy), CI-2481, CI-2624, CI-2639, CI-2064 (manufactured by Nippon Soda Co., Ltd.), CD-1010, CD-1011, CD-1012 (manufactured by Sartomer Co., Ltd.), DTS-102, DTS-103, NAT-103, NDS-103, TPS-103, MDS-103, MPI-103, BBI-103 (manufactured by Midori Chemical Co., Ltd.). Among these, UVI-6970, UVI-6974, Adekaoptomer SP-170, SP-171, CD-1012, MPI-103 are particularly preferable to develop high curing sensitivity of the resin composition which contains these compounds.

The above-mentioned cationic photo-initiators can be used as the component (B) either individually or in combination of two or more.

The proportion of the component (B) in the photo-curable resin composition is 0.1-10% by weight, preferably 0.2-5% by weight, and more preferably 0.3-3% by weight. If the proportion of the component (B) is too low, the photo-curing characteristic of the resin composition obtained is insufficient. No three-dimensional object having sufficient mechanical strength can be produced from this resin composition. On the other hand, if the proportion of the component (B) is too high, an appropriate light capability (curing depth) cannot be obtained when the resulting resin composition is used in the photo-fabrication process. Mechanical strength such as the toughness of the three-dimensional object prepared from this resin composition tends to be reduced.

<Ethylenically unsaturated monomer>

The ethylenically unsaturated monomer (hereinafter called [component (C)]) is a compound having ethylenically unsaturated groups (C=C) in the molecule. Given as typical examples of the component (C) are mono-functional monomers having one ethylenically unsaturated bond in one molecule, and polyfunctional monomers having two or more ethylenically unsaturated bonds in one molecule. Given as examples of the mono-functional monomer used as the component (C) are acrylamide, (meth)acryloyl morpholine, 7-amino-3,7-dimethyloctyl (meth)acrylate, isobutoxymethyl (meth)acrylamide, isobornyloxyethyl (meth)acrylate, isobornyl (meth)acrylate, 2-ethylhexyl (meth)acrylate, ethyldiethylene glycol (meth)acrylate, t-octyl (meth)acrylamide, diacetone (meth)acrylamide, dimethylaminoethyl (meth)acrylate, diethylaminoethyl (meth)acrylate, lauryl (meth)acrylate, dicyclopentadiene (meth)acrylate, dicyclopentenyloxyethyl (meth)acrylate, dicyclopentenyl (meth)acrylate, N,N-dimethyl (meth)acrylamide tetrachlorophenyl (meth)acrylate, 2-tetrachlorophenoxyethyl (meth)acrylate, tetrahydrofurfuryl (meth)acrylate, tetrabromophenyl (meth)acrylate, 2-tetrabromophenoxyethyl (meth)acrylate, 2-trichlorophenoxyethyl (meth)acrylate, tribromophenyl (meth)acrylate, 2-tribromophenoxyethyl (meth)acrylate, 2-hydroxyethyl (meth)acrylate, 2-hydroxypropyl (meth)acrylate, vinyl caprolactam, N-vinyl pyrrolidone, phenoxyethyl (meth)acrylate, butoxyethyl (meth)acrylate, pentachlorophenyl (meth)acrylate, pentabromophenyl (meth)acrylate, polyethylene glycol mono-(meth)acrylate, polypropylene glycol mono-(meth)acrylate, bornyl (meth)acrylate, methyltriethylene diglycol (meth)acrylate, and, the compounds shown in the following general formula (2) or (3).

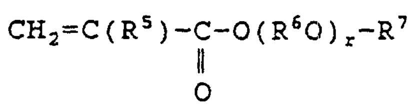

(2)

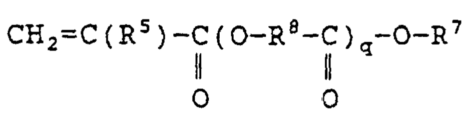

(3)

wherein $R^5$ represents a hydrogen atom or a methyl group, $R^6$ represents an alkylene group containing 2-6, preferably

2-4 carbon atoms, $R^7$ represents a hydrogen atom or an alkyl group containing 1-20, preferably 1-12 carbon atoms in which $R^7$ may comprise ethergroups like in a dioxane or tetrahydrofuran group; or $R^7$ denotes an aromatic group optionally substituted with a $C_1$-$C_{12}$, alkyl group, preferably a $C_{8-9}$ alkyl group, $R^8$ represents an alkylene group containing 2-8, preferably 2-5 carbon atoms, r denotes an integer from 0-12, preferably from 1-8, and q denotes an integer from 1-8, preferably from 1-4.

Among these monofunctional monomers, isobornyl (meth)acrylate, lauryl (meth)acrylate, and phenoxyethyl (meth)acrylate are particularly preferable.

Given as examples of commercially available products of the monofunctional monomers are Aronix M-101, M-102, M-111, M-113, M-117, M-152, TO-1210 (manufactured by Toagosei Chemical Industry Co., Ltd.), KAYARAD TC-110S, R-564, R-128H (manufactured by Nippon Kayaku Co., Ltd.), Viscoat 192, Viscoat 220, Viscoat 2311HP, Viscoat 2000, Viscoat 2100, Viscoat 2150, Viscoat 8F, Viscoat 17F (manufactured by Osaka Organic Chemical Industry Co., Ltd.)

Given as preferable examples of the polyfunctional monomers used as the component (C) are ethylene glycol di(meth)acrylate, dicyclopentenyl di(meth)acrylate, triethylene glycol diacrylate, tetra ethylene glycol di(meth)acrylate, tricyclodecanediyldimethylene di(meth)acrylate, tris(2-hydroxyethyl) isocyanurate di(meth)acrylate, tris(2-hydroxyethyl) isocyanurate tri(meth)acrylate, caprolactone modified tris(2-hydroxyethyl) isocyanurate tri(meth)acrylate, trimethylolpropane tri(meth)acrylate, ethylene oxide (hereainafter called [EO]) modified trimethylolpropane tri(meth)acrylate, propylene oxide (hereinafter called as [PO] as the case may be) modified trimethylolpropane tri(meth)acrylate, tripropylene glycol di(meth)acrylate, neopentyl glycol di(meth)acrylate, both terminal (meth)acrylic acid adduct of bisphenol A diglycidyl ether, 1,4-butanediol di(meth)acrylate, 1,6-hexanediol di(meth)acrylate, pentaerythritol tri(meth)acrylate, pentaerythritol tetra(meth)acrylate, polyester di(meth)acrylate, polyethylene glycol di(meth)acrylate, dipentaerythritol hexa(meth)acrylate, dipentaerythritol penta(meth)acrylate, dipentaerythritol tetra(meth)acrylate, caprolactone modified dipentaerythritol hexa(meth)acrylate, caprolactone modified dipentaerythritol penta(meth)acrylate, ditrimethylolpropane tetra(meth)acrylate, EO modified bisphenol A di(meth)acrylate, PO modified bisphenol A di(meth)acrylate, EO modified hydrogenated bisphenol A di(meth)acrylate, PO modified hydrogenated bisphenol A di(meth)acrylate, EO modified bisphenol F di(meth)acrylate, and phenol novolac polyglycidyl ether.

Given as commercially available products of these polyfunctional monomers are SA1002 (manufactured by Mitsubishi Chemical Co., Ltd.), Viscoat 195, Viscoat 230, Viscoat 260, Viscoat 215, Viscoat 310, Viscoat 214HP, Viscoat 295, Viscoat 300, Viscoat 360, Viscoat GPT, Viscoat 400, Viscoat 700, Viscoat 540, Viscoat 3000, Viscoat 3700 (manufactured by Osaka Organic Chemical Industry Co., Ltd.), KAYARAD R-526, HDDA, NPGDA, TPGDA, MANDA, R-551, R-712, R-604, R-684, PET-30, GPO-303, TMPTA, THE-330, DPHA, DPHA-2H, DPHA-2C, DPHA-21, D-310, D-330, DPCA-20, DPCA-30, DPCA-60, DPCA-120, DN-0075, DN-2475, T-1420, T-2020, T-2040, TPA-320, TPA-330, RP-1040, RP-2040, R-011, R-300, R-205 (manufactured by Nippon Kayaku Co., Ltd.), Aronix M-210, M-220, M-233, M-240, M-215, M-305, M-309, M-310, M-315, M-325, M-400, M-6200, M-6400 (manufactured by Toagosei Chemical Industry Co., Ltd.), Light acrylate BP-4EA, BP-4PA, BP-2EA, BP-2PA, DCP-A (manufactured by Kyoeisha Chemical Industry Co., Ltd.), New Frontier BPE-4, TEICA, BR-42M, GX-8345 (manufactured by Daiichi Kogyo Seiyaku Co., Ltd.), ASF-400 (manufactured by Nippon Steel Chemical Co., Ltd.), Ripoxy SP-1506, SP-1507, SP-1509, VR-77, SP-4010, SP-4060 (manufactured by Showa Highpolymer Co., Ltd.), and NK Ester A-BPE-4 (manufactured by Shin-Nakamura Chemical Industry Co., Ltd.).

The component (C) which is a constituent of the photo-curable resin composition of the present invention contains more than 60% by weight of the polyfunctional monomer having three or more ethylenically unsaturated bonds in one molecule. The proportion of the polyfunctional monomer having three or more functional groups is preferably more than 70% by weight and more preferably more than 80% by weight. A particularly preferable proportion of the polyfunctional monomer is substantially 100% by weight. If the proportion of the polyfunctional monomer having three or more functional groups is less than about 60% by weight, the photo-curing characeristic of the resulting resin composition is insufficient and the three-dimensional object fabricated tends to deform with time.

The polyfunctional monomer having three or more polyfunctional groups can be selected from the above-mentioned tri(meth)acrylate compounds, tetra(meth)acrylate compounds, penta(meth)acrylate compounds, and hexa(meth)acrylate compounds. Among these, trimethylol propane tri(meth)acrylate, EO modified trimethylolpropane tri(meth)acrylate, dipentaerythritol hexa(meth)acrylate, dipentaerythritol penta(meth)acrylate, and ditrimethylolpropane tetra(meth) acrylate are particularly preferable.

The above-mentioned monofunctional monomers and polyfunctional monomers can be used as the component (C) either individually or in combinations of two or more.

The proportion of the monofunctional monomer and polyfunctional monomer in the photo-curable resin composition of the present invention is generally 5-30% by weight, preferably 7-25% by weight, and more preferably 10-20% by weight. If the proportion of the component (C) is too low, the photo-curing characteristic of the resin composition is insufficient. No three-dimensional object having sufficient mechanical strength can be fabricated from such resin composition. On the other hand, if the proportion of the composition (C) is too high, the resulting resin composition shrinks easily during by photo-curing and the mechanical strength such as toughness of the three-dimensional object tends

to be reduced.

<Radically photo-initiator>

The radical photo-initiator (hereinafter called [component (D)]) which is a constituent of the photo-curable resin composition of the present invention is a compound which decomposes and generates radicals by receiving radiation such as light and initiates a radical polymerization reaction of the component (C) by the action of the radicals.

Given as specific examples of the radical photo-initiators which can be used as the component (D) are acetophenone, acetophenone benzyl ketal, anthraquinone, 1-(4-isopropylphenyl)-2-hydroxy-2-methylpropan-1-one, carbazole, xanthone, 4-chlorobenzo-phenone, 4,4'-diaminobenzophenone, 1,1-dimethoxydeoxybenzoin, 3,3'-dimethyl-4-methoxybenzophenone, thioxanethone compounds, 2-methyl-1-4-(methylthio) phenyl-2-morpholino-propane-2-on, 2-benzyl-2-dimethylamino-1-(4-morpholinophenyl)-butan-1-one, triphenylamine, 2,4,6-trimethylbenzoyl diphenylphosphine oxides, bis (2,6-dimethoxybenzoyl)-2,4,4-tri-methylpentyl-phosphine oxide, benzyl dimethyl ketal, 1-hydroxycyclohexyl phenyl ketone, 2-hydroxy-2-methyl-1-phenylpropane-1-one, fluorenone, fluorene, benzaldehyde, benzoin ethyl ether, benzoin propyl ether, benzophenone, Michler's ketone, 3-methylacetophenone, 3,3', 4,4'-tetra (t-butyl peroxycarbonyl) benzophenone (BTTB), and combined compositions of BTTB and xanthene, thioxanthene, cumarin, ketocumarin or other coloring matter photosensitizer. Among these, benzyl dimethyl ketal, 1-hydroxycyclohexyl phenyl ketone, 2,4,6-trimethylbenzoyl diphenylphosphine oxide, 2-benzyl-2-dimethylamino-1-(4-morpholinophenyl)-butan-1 -one, and the like are particularly preferred.

The above-mentioned radical photo-initiators can be used as the component (D) either individually or in combinations of two or more.

The proportion of the component (D) in the photo-curable resin composition of the present invention is usually 0.01-10% by weight and preferably 0.1-8% by weight. If the proportion of the component (D) is too low, the rate (curing rate) of the radical polymerization is so reduced that fabricating time may be extended and the resolution may tend to be lower. On the other hand, if the proportion of the component (D) is too high, the excess photo-initiator sometimes has an adverse effect on the curing characteristics of the resin composition and the specification, heat resitance, and handling of the three-dimensional object obtained from the resin composition.

<Polyether polyol>

The polyether polyol (hereinafter called [component (E)]) is an essential component for developing the photo-curability of the resin composition and the shape stability (resistance to deformation with time) of the three-dimensional object obtained from the resin composition. The polyether polyol used as the component (E) has on average about three or more, preferably about 3-6 hydroxyl groups in the molecules. If polyether polyols having less than three hydroxyl groups are used (e.g. polyether diols), the aim of developing the photo-curing characteristic can not be achieved and a three-dimensional object with sufficient mechanical strength can not be produced. On the other hand, if polyether polyols having on average 7 or more hydroxyl groups are used, the extensibility and toughness of the three-dimensional object obtained from the resin composition tends to be lower.

Given as specific examples of the component (E) are polyether polyols prepared by modifing polyhydric alcohol of more than 3 valences such as trimethylolpropane, glycerol, pentaerythritol, sorbitol, sucrose, polyether polyols or the like by a cyclic ether compound such as ethylene oxide (EO), propylene oxide (PO), butylene oxide, tetrahydrofuran, and the like. Specific examples of such polyether polyols are EO modified trimethylolpropane, PO modified trimethylolpropane, tetrahydrofuran modified trimethylolpropane, EO modified glycerol, PO modified glycerol, tetrahydrofuran modified glycerol, EO modified pentaerythritol, PO modified pentaerythritol, tetrahydrofuran modified pentaerythritol, EO modified sorbitol, PO modified sorbitol, EO modified sucrose, PO modified sucrose, EO modified quodor. Among these, EO modified trimethylolpropane, PO modified trimethylolpropane, PO modified glycerol, PO modified sorbitol are desirable.

The preferable molecular weight of the polyether polyol is 100 to 2,000, and more preferably 160-1,000. If polyether polyols having too small molecular weight are used as the component (E), it is difficult to prepare a three-dimensional object with stable in shape and properties. On the other hand, If polyether polyols having too large molecular weight are used as the component (E), the viscosity of the resulting resin composition becomes too large, resulting in lowering of the mechanical strength of the three-dimensional object obtained by the photo-fabrication process.

Given as specific examples of the polyether polyols which can be used as the component (E) are Sunnix TP-400, Sunnix GP-600, Sunnix GP-1000, Sunnix SP-750, Sunnix GP-250, Sunnix GP-400, Sunnix GP-600 (manufactured by Sanyo Chemical Co., Ltd.), TMP-3 Glycol, PNT-4 Glycol, EDA-P-4, EDA-P-8 (manufactured by Nippon Nyukazai Co., Ltd.), and G-300, G-400, G-700, T-400, EDP-450, SP-600, SC-800 (manufactured by Asahi Denka Kogyo Co., Ltd.).

The above-mentioned polyether polyols can be used as the component (E) either individually or in combinations of two or more.

The proportion of the component (E) in the photo-curable resin composition of the present invention is usually 5-30% by weight, preferably 7-25% by weight, and more preferably 10-20% by weight. If the proportion of the component (E) is too low, the aim of developing the photo-curing characteristic can not be achieved and there are cases where a three-dimensional object with sufficient stability in shape and properties can not be produced from the resin composition. On the other hand, if the proportion of the component (E) is too high, the photo-curing characteristics of the resin composition are degraded and there is a tendency for the mechanical strength of the three-dimensional object obtained from the resin composition to be reduced.

<Optional components>

In addition to the above-mentioned components (A) to (E), various other components may be incorporated into the photo-curable resin composition of the present invention to the extent that the curability of this composition is not adversely affected. Such optional components include photosensitizers (polymerization promoters) of amine compounds such as triethanolamine, methyl diethanolamine, triethylamine, diethylamine; photosensitizers including thioxantone or its derivatives, anthraquinone or its derivatives, anthracene or its derivatives, perillene and its derivatives, benzophenone, benzoin isopropylether, and the like; and reaction diluents such as vinyl ether, vinyl sulfide, vinyl urethane, or vinyl urea. Also, various additives may be incorporated into the photo-curable resin composition. Such additives include polymers or oligomers, such as epoxy resin, polyamide, polyamideimide, polyurethane, polybutadiene, polychloroprene, polyether, polyester, styrene-butadiene-styrene block copolymer, petroleum resin, xylene resin, ketone resin, cellulose resin, fluorine oligomer, silicon oligomer, and polysulfide oligomer; polymerization inhibitors such as phenothiazine or 2,6-di-t-butyl-4-methyl phenol, polymerization initiation adjuvants, leveling agents, wettability improvers, surfactants, plasticizers, UV absorbers, silane coupling agents, inorganic fillers, resin particles, pigments, dyes and the like. The photo-curable resin composition of the present invention can be manufactured by homogeneously blending the above-mentioned components (A) to (E), the optional components, and the various additives.

It is desirable for the photo-curable resin composition of the present invention to possess a viscosity at 25°C in the range of 50-1,000 mPa.s (cps), preferably 70-500 mPa.s (cps).

Photo-fabricating process>

The photo-curable resin composition of the present invention prepared in this manner is suitable as a photo-curable (liquid) material used in photo-fabrication processes. Specifically, a three-dimensional object with a desired shape can be obtained by using the photo-fabrication process, including selectively irradiating visible light, ultraviolet light, or infrared light on the photo-curable resin composition of the present invention, and feeding the energy required to cure the resin composition.

Various means may be used to selectively irradiate the photo-curable resin composition with light with no specific limitations. Such light irradiation means include, for example, a laser beam, a means for irradiating the composition with light and the like converged by a lens, mirror, or the like, while scanning, a means irradiating the composition with non-convergent light . through a mask provided with a fixed pattern through which light is transmitted, and a means for irradiating the composition with light via a number of optical fibers bundled in a light conductive member corresponding to a fixed pattern. In the means using a mask, a mask electrooptically produces a mask image consisting of a light transmitting area and non-light-transmitting area according to a prescribed pattern by the same theory as that of the liquid crystal display apparatus. A means using a scanning laser beam with a small spot size is preferred for selectively irradiating the resin composition with light, when a resulting three-dimensional object possesses minute parts or when high dimensional accuracy is required to form the three-dimensional object.

In the above means, the irradiated surface (for example, the plane scanned by light) of the resin composition placed in a vessel is either the liquid level of the resin composition or the surface at which the liquid contacts the wall of a transparent vessel. When the irradiated surface is the liquid level or the contact surface of the wall of the vessel, the light can be shone directly out of the vessel or through the vessel.

In the above photo-fabrication process, a desired solid shape can be made by curing fixed parts of the resin composition and then moving the light spot from the cured parts to the uncured parts continuously or gradually to laminate the cured parts. There are various methods for moving the light spot, for example, a method for moving any of the light source, the vessel for the resin composition, or the cured parts of the resin composition. Also there is a method in which fresh resin composition is supplied to the cured resin composition in the vessel.

In a typical photo-fabrication process, the surface of a support stage capable of being elevated in the vessel is lowered quite a bit from the liquid surface to form a thin layer (1) of the resin composition, the thin layer (1) is selectively irradiated with light to form a solid cured resin layer (1'). The resin composition is supplied over this thin

layer (1') to form a second thin layer (2), and this thin layer (2) is selectively irradiated with light to laminate a new solid cured resin layer (2') on the thin layer (1'). This step is repeated for a prescribed number of times, with or without changing the pattern subjected to light irradiation, to produce a three-dimenntional object consisting of a multiple number of cured resin layers (n') which are integrally laminated.

The three-dimensional object fabricated in this manner is discharged from the vessel and processed to remove the unreacted photo-curable resin composition remaining on the surface, and washed by a solvent, as required. Given as examples of solvents are an organic solvent which is represented by an alcohol, such as isopropyl alcohol or ethyl alcohol, an organic solvent such as acetone, ethyl acetate, methylethyl ketone, an aliphatic organic solvent such as a terpene, or a low viscosity liquid thermosetting resin or photo-curable resin.

When forming a three-dimensional object with a smooth surface, it is desirable that the cured product be washed using the thermosetting resin or photo-curable resin. In this case, it is necessary to post-cure the product by heat emission or light irradiation depending on the type of solvent used in the washing stage. This post-curing treatment is effective not only for curing the resin remaining uncured on the surface of the laminated body, but alse for curing the resin composition which remains uncured inside the laminated body. Thus, the post-curing treatment is also effective in the case where the fabricated three-dimensional object is washed with an organic solvent.

The three-dimensional object obtained in this manner has high mechanical strength, high dimensional accuracy, and excellent heat resistance. Also, the three-dimensional object exhibits high stability in maintaining a fixed shape and lasting stable properties. Therefore, the three-dimensional object prepared from the resin composition is preferably used for trial products for mechanical parts.

It is desirable to cover the surface of the three-dimensional object by a heat-curable or photo-curable hard coating agent to improve the strength and heat resistance of the surface. As such a hard coating agent, an organic coating agent such as acryl resin, epoxy resin, silicon resin, or the like, or an inorganic coating agent can be used. These hard coating agents may be used individually or in combination of two or more.

## EXAMPLES

The present invention will be explained in more detail by way of examples, which are not intended to be limiting of the present invention. In the examples, unless otherwise stated, the % by weight values are relative to the total weight of the composition.

### <Example 1>

According to the formulation shown in Table 1, 48% by weight of 3,4-epoxycyclohexylmethyl-3',4'-epoxycyclohexane carboxylate (UVR-6110, manufactured by Union Carbide), 16% by weight of butanedioldiglycidyl ether (KRM-2720, manufactured by Asahi Denka Kogyo), 5% by weight of trimethylolpropane triacrylate (Viscoat 295, manufactured by Osaka Organic Chemical), 5% by weight of dipentaerythritol hexaacrylate (KAYARAD DPHA, manufactured by Nippon Kayaku), 5% by weight of bisphenol A diglycidylether diacrylate (Novacure 3700, manufactured by Radcure), 2% by weight of triallylsulfoniumhexafluoro antimonate (UVI-6974, manufactured by Union Carbide), 0.2% by weight of diethylthioxantone (DETX-S, manufactured by Nippon Kayaku), 2% by weight of 1-hydroxycyclohexylphenylketone (Irgacure 184, manufactured by Ciba Geigy), and 17% by weight of PO modified glycerol (Sunnix GP-250, manufactured by Sanyo Chemical) were placed in a vessel equipped with a stirrer and the mixture was reacted with stirring at 60°C for one hour to prepare a transparent liquid composition (the resin composition of the present invention). The viscosity of the liquid composition resulting was measured at 25°C by means of a B type viscometer. The viscosity of the composition was 150 mPa.s (cps).

### <Examples 2-9>

Transparent liquid compositions (the photo-curable resin compositions of the present invention) were prepared as the same manner as in Example 1 according to the formulations shown in Table 1, except that the different components were used. The viscosity (at 25°C) of the liquid compositions prepared were each measured by a B-type viscometer. The results are shown in Table 1.

### <Comparative Examples A-D>

Transparent liquid compositions (comparative photo-curable resin compositions) were prepared in the same manner as in Example 1 according to the formulations shown in Table 1, except that the different components and optional components were used. The viscosity (at 25°C) of the prepared liquid compositions were each measured by a B-type viscometer. The results are shown in Table 1.

TABLE 1

| Amounts in wt.%, relative to the total composition | EXAMPLE | | | | | | | | | COMPARATIVE EXAMPLE | | | |
|---|---|---|---|---|---|---|---|---|---|---|---|---|---|
| | 1 | 2 | 3 | 4 | 5 | 6 | 7 | 8 | 9 | A | B | C | D |
| Component A | | | | | | | | | | | | | |
| - 3,4-Epoxycyclohexyl-methyl-3',4'-epoxy-cyclohexane carboxylate | 48 | 48 | 48 | 48 | 48 | 48 | 48 | 48 | 48 | 48 | 48 | 48 | 48 |
| - Butanediol diglycidyl ether | 16 | 18 | 18 | 18 | 18 | 16 | 18 | 16 | 18 | 18 | 18 | 18 | 18 |
| Component B | | | | | | | | | | | | | |
| Triarylsulfonium hexafluoroantimonate | | | | | | | | | | | | | |
| - UVI-6974[*1] | 2 | 2 | - | - | 2 | 2 | 1 | 2 | 2 | 2 | 1 | 2 | 2 |
| - UVI-6970[*1] | - | - | 2 | - | - | - | - | - | - | - | - | - | - |
| - SP-171[*2] | - | - | - | 2 | - | - | - | - | - | - | - | - | - |
| Component C | | | | | | | | | | | | | |
| - Trimethylolpropane triacrylate | 5 | 8 | 8 | 8 | 8 | 8 | 8 | 5 | 8 | 8 | - | - | 8 |
| - Dipentaerythritol hexacrylate | 5 | 5 | 5 | 5 | 5 | 5 | 5 | 5 | 5 | 5 | 4 | 4 | 5 |
| - Bisphenol A diglycidyl ether diacrylate | 5 | - | - | - | - | - | - | 5 | - | - | 8 | 8 | - |
| Component (D) | | | | | | | | | | | | | |
| 1-Hydroxycyclohexyl phenyl ketone | 2 | 2 | 2 | 2 | 2 | 2 | 1 | 2 | 2 | 2 | 1 | 2 | 2 |

| | | | | | | | | | | | | | |
|---|---|---|---|---|---|---|---|---|---|---|---|---|---|
| Component (B) | | | | | | | | | | | | | |
| - PO-modified glycerine | 17 | 17 | 17 | 17 | - | - | - | 17 | - | - | - | 17 | - |
| - PO-modified trimethylol-propane *3 | - | - | - | - | 12 | - | - | - | - | - | - | - | - |
| - EO-modified trimethylol-propane *4 | - | - | - | - | - | 17 | - | - | - | - | - | - | - |
| - PO-modified sorbitol *5 | - | - | - | - | - | - | 19 | - | - | - | - | - | - |
| - Polyether polyol *6 | - | - | - | - | - | - | - | - | 17 | - | - | - | - |

| Amounts in wt.%, relative to the total composition | EXAMPLE | | | | | | | | | COMPARATIVE EXAMPLE | | | |
|---|---|---|---|---|---|---|---|---|---|---|---|---|---|
| Optional Component<br>- Diethylthioxanetone *7<br>- 1,4-Buthenediol adipic acid ester *8 | 0.2<br>- | -<br>- | -<br>- | -<br>- | -<br>5 | -<br>- | -<br>- | -<br>- | -<br>- | -<br>- | -<br>- | -<br>- | -<br>17 |
| Caprolactone triol *9 | - | - | - | - | - | - | - | - | - | 17 | 20 | - | - |
| Viscosity (25°C) (mPa.s (cps)) | 150 | 110 | 110 | 110 | 150 | 100 | 250 | 150 | 170 | 160 | 220 | 160 | 220 |

*1) [UVI-6974], [UVI-6970] (manufactured by Union Carbide Corporation)

*2) [SP-171] (manufactured by Asahi Denka Industries Co., Ltd.)

*3) [Sunnix GP-400] (manufactured by Sanyo Chemical Co., Ltd.)

*4) [TMP-30U] (manufactured by Nippon Nyukazai Kogyo Co., Ltd.)

*5) [Sunnix SP-750] (manufactured by Sanyo Chemical CO., Ltd.)

*6) [Desmophenon 1915] (manufactured by Bayer )

*7) A photosensitizer

*8) [Nipporan 4009] (manufactured by Nippon Polyurethane Industries Co., Ltd.)

*9) [TONE-0301] (manufactured by Union Carbide Corporation)

As shown in Table 1, all the compositions prepared in Examples 1 to 9 have an optimum viscosity as the resin composition used in the photo-fabrication process.

<Evaluation of photo-curable resin compositions>

The photo-curable resin compositions prepared in Examples 1-9 and Comparative Examples A-D were evaluated by measuring the Young's modulus of the cured products and the deformation rate with time. The results are shown in Table 2.

<Change in Young's modulus with time>

(1) Preparation of test specimens

A coated film with a thickness of 200 µm was prepared by applying a composition to a glass plate using an applicator. The surface of the film was irradiated with ultraviolet light at a dose of 0.5 $J/cm^2$ using a conveyer curing apparatus equipped with a metal halide lamp to prepare a half-cured resin film. Next, the half cured resin film was peeled from the glass plate and placed on releasable paper. The side opposite to that first cured by irradiation was irradiated with ultraviolet light at a dose of 0.5 $J/cm^2$ to prepare a completely cured resin film.

The cured resin film was allowed to stand under the atmospheric conditions described below to produce three test specimens (1) to (3).

Specimen (1) was prepared at a temperature of 23°C, under a humidity of 50% and allowed to stand in a thermo-hygrostat for 24 hours.

Specimen (2) was prepared at a temperature of 23°C, under a humidity of 50% and allowed to stand in a thermo-hygrostat for 30 days.

Specimen (3) was prepared at a temperature of 23°C, under a humidity of 80% and allowed to stand in a thermo-hygrostat for 30 days.

(2) Measurement of Young's modulus

The Young's modulus of the test specimen was measured at a temperature of 23°C under a humidity of 50% under the conditions of a drawing rate of 1 mm/min and a bench mark distance of 25 mm.

[Rate of deformation with time]

(1) Preparation of test specimen

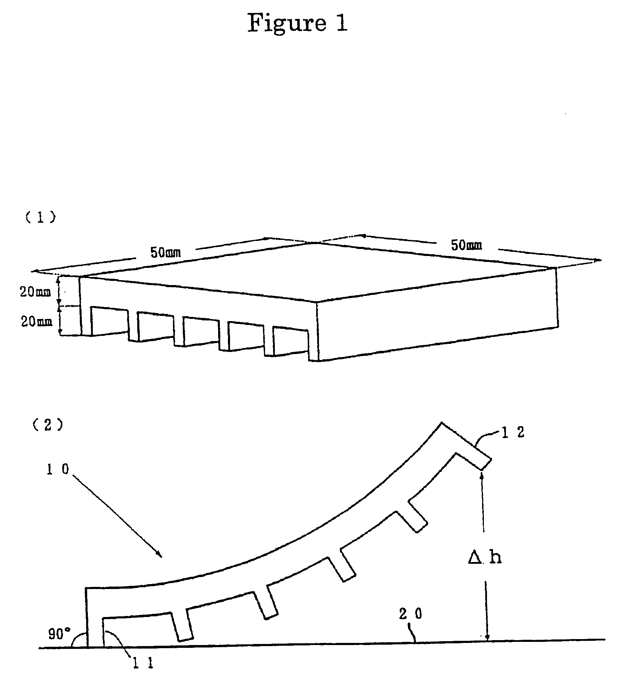

Using an photo-fabrication apparatus (Solid Creator JSC-2000, manufactured by Sony Corporation) equipped with a light source for applying an argon ion laser beam (wave length of 351 nm and 365 nm), a photo-curable resin composition was selectively irradiated by the laser beam under the conditions of a laser power of 100 mW measured on the irradiated surface (liquid level) and a scanning speed of 400 mm/s to form a cured resin film with a thickness of 0.15 mm. This fabricating procedure was repeated many times to form a model for measurement (hereinafter called [camber model]) as shown in Fig. 1. The camber model was then discharged from the photo-fabrication apparatus, after which the residual resin composition adhering to the outer surface of the camber model was released, and the excess resin composition was removed using a terpene-type solvent.

(2) Measurement

As shown in Fig.1, measurements were made by securing a foot -part 11 of a camber model 10 to a plane 20 and measuring the distance (lift length $\Delta h$ (mm)) between the plane 20 and the bottom of a foot part 12 to determine the primary camber rate.

After the camber model 10 was allowed to stand in a thermo-hygrostat at 23°C under a humidity of 50% for 3 days, the camber rate was measured in the same manner as in the above procedure.

TABLE 2

| | Changes with time of Young's modulus ($kg/mm^2$) | | | Changes with time | |
|---|---|---|---|---|---|
| | Specimen (1) | Specimen (2) | Specimen (3) | Warping (mm) | |
| | Temp., humidity, time period allowed to stand | | | Initial value | After 30 days |
| | 23°C, 50%, 24Hrs | 23°C, 50%, 30Days | 23°C, 80%, 30Days | | |
| Example | | | | | |
| 1 | 150 | 145 | 140 | 0.00 | 0.10 |
| 2 | 170 | 170 | 160 | 0.00 | 0.02 |
| 3 | 170 | 170 | 160 | 0.00 | 0.02 |
| 4 | 170 | 170 | 160 | 0.00 | 0.02 |
| 5 | 155 | 140 | 140 | 0.02 | 0.09 |
| 6 | 160 | 170 | 155 | 0.00 | 0.04 |
| 7 | 185 | 190 | 170 | 0.00 | 0.05 |
| 8 | 150 | 135 | 120 | 0.01 | 0.15 |
| 9 | 130 | 110 | 100 | 0.04 | 0.12 |

| | Changes with time of Young's modulus ($kg/mm^2$) | | | Changes with time | |
|---|---|---|---|---|---|
| | Specimen (1) | Specimen (2) | Specimen (3) | Warping (mm) | |
| | Temp., humidity, time period allowed to stand | | | Initial value | After 30 days |
| | 23°C, 50%, 24Hrs | 23°C, 50%, 30Days | 23°C, 80%, 30Days | | |
| Comparative Example | | | | | |
| A | 165 | 110 | 70 | 0.02 | 0.42 |
| B | 140 | 70 | 10 | 0.00 | 0.58 |
| C | 130 | 80 | 60 | 0.02 | 0.22 |
| D | 120 | 85 | 35 | 0.10 | 0.22 |

As is clear from Table 2, all cured products from the photo-curable resin compositions of the present invention prepared in the Examples 1-9, especially Examples 1-7 had excellent mechanical properties with a large Young's modulus and a lasting small chamber rate.

In contrast, the cured product formed from the composition prepared in the Comparative Example A, using caprolactone modified triol (polyester polyol) instead of the component (E) exhibited a large change in the Young's modulus and minimal deformation with time.

Evaluations were made for the cured products formed from the following compositions prepared from Comparative Examples: the composition prepared in Comparative Example B, using caprolactone modified triol instead of the component (E) and containing less than 60% by weight of a poly functional monomer having three or more polyfunctional groups in the component (C); the composition prepared in Comparative Example C, contaning less than 60% by weight of a polyfunctional monomer having three or more polyfunctional groups in the component (C), although the composition contained the component (E); and the composition prepared in Comparative Example D, using adipic ester of 1,4 butane diol instead of the component (E). All these cured products from the compositions prepared from the Comparative Examples had low mechanical strength with a small Young's modulus, and a large change in Young's modulus and camber rate with time. The photo-curable resin composition of the present invention can produce cured products having little change in mechanical properties and deformation rate with time, maintaining high dimensional accuracy, and exhibiting excellent mechanical strength and heat resistance. The cured product can therefore be suitably used as a three-dimensional object, for example, a trial product for mechanical parts. In addition, the photo-fabrication process using the photo-curable resin composition of the present invention can provide a three-dimensional object possessing excellent primary characteristics and high durability.

BRIEF DESCRIPTION OF THE DRAWINGS

Figure 1 is a diagram showing the configuration of the model for the measurement of deformation rate with time and explaining measuring method.

DESCRIPTION OF SYMBOLS

10 Camber model
11, 12 Foot part
20 Plane

## Claims

1. A photo-curable resin composition comprising,

    (A) a cationic polymerizable organic compound,
    (B) a cationic photo-initiator,
    (C) an ethylenically unsaturated monomer,
    (D) a radical photo-initiator, and
    (E) a polyether polyol having on average about three or more hydroxyl groups, wherein at least 60% by weight, relative to the total composition, of the said ethylenically unsaturated monomer is a polyfunctional monomer having three or more ethylenically unsaturated bonds in one molecule.

2. A photo-curable resin composition according to claim 1, wherein the composition has been formulated from components comprising, relative to the total composition:

    30-85 wt.% of component (A)
    0.1-10 wt.% of component (B)
    5-30 wt.% of component (C)
    0.1-10 wt.% of component (D)
    5-30 wt.% of component (E).

3. A photo-curable resin composition according to claim 1 wherein the composition has a viscosity at 25°C in the range of 50-1000 mPa.s (cps).

**4.** A photo-curable composition according to claim 1, wherein component (A) is a compound comprising at least one epoxy group.

**5.** A photo-curable composition according to claim 1, wherein component (C) is a compound comprising at least one (meth)acrylate group.

**6.** A photo-curable composition according to claim 1, wherein component (E) has on average 3-6 hydroxyl groups.

**7.** A photo-curable composition according to claim 1, wherein component (E) has a molecular weight of 100-2,000.

**8.** Process for the fabrication of a three-dimensional object comprising the steps of forming a curable resin layer having a specified pattern by selectively irradiating with light feeding the photo-curable resin composition equivalent to one layer to form another thin layer of the composition over this cured resin layer, and selectively irradiating this thin layer with light to form a new cured resin layer which is integrally laminated over the previously formed cured resin layer and repeating this step a number of times, with or without changing the pattern in which the light is irradiated to form a three-dimensional object consisting of integrally laminated multiple cured resin layers, wherein a resin composition according to any one of claims 1-7 is used.

## Patentansprüche

**1.** Photohärtbare Harzzusammensetzung, umfassend

(A) eine kationisch polymerisierbare organische Verbindung,
(B) einen kationischen Photoinitiator,
(C) ein ethylenisch ungesättigtes Monomer
(D) einen freie Radikale erzeugenden Photoinitiator, und
(E) ein Polyetherpolyol, welches im Mittel etwa drei oder mehr Hydroxylgruppen aufweist, wobei mindestens 60 Gew.-%, bezogen auf die Gesamtzusammensetzung, des ethylenisch ungesättigten Monomers ein polyfunktionales Monomer ist, welches drei oder mehr ethylenisch ungesättigte Bindungen in einem Molekül aufweist.

**2.** Photohärtbare Harzzusammensetzung gemäß Anspruch 1, wobei die Zusammensetzung aus Komponenten formuliert wurde, welche, bezogen auf die Gesamtzusammensetzung

30-85 Gew.-% der Komponente (A)
0,1-10 Gew.-% der Komponente (B)
5-30 Gew.-% der Komponente (C)
0,1-10 Gew.-% der Komponente (D)
5-30 Gew.-% der Komponente (E)

umfassen.

**3.** Photohärtbare Harzzusammensetzung gemäß Anspruch 1, wobei die Zusammensetzung eine Viskosität bei 25°C im Bereich von 50-1000 mPa.s (cP) aufweist.

**4.** Photohärtbare Harzzusammensetzung gemäß Anspruch 1, wobei die Komponente (A) eine Verbindung ist, welche mindestens eine Epoxidgruppe umfaßt.

**5.** Photohärtbare Zusammensetzung gemäß Anspruch 1, wobei die Komponente (C) eine Verbindung ist, welche mindestens eine (Meth)acrylatgruppe umfaßt.

**6.** Photohärtbare Zusammensetzung gemäß Anspruch 1, wobei die Komponente (E) im Mittel 3-6 Hydroxylgruppen aufweist.

**7.** Photohärtbare Zusammensetzung gemäß Anspruch 1, wobei die Komponente (E) ein Molekulargewicht von 100-2000 aufweist.

8. Verfahren zur Herstellung eines dreidimensionalen Gegenstandes, umfassend die Schritte des Formens einer härtbaren Harzschicht mit einem spezifischen Muster durch selektives Bestrahlen mit Licht, Einspeisens der einer Schicht äquivalenten photohärtbaren Harzzusammensetzung, um eine andere dünne Schicht der Zusammensetzung über dieser gehärteten Harzschicht zu bilden, und selektiven Bestrahlens dieser dünnen Schicht mit Licht, um eine neue gehärtete Harzschicht zu bilden, welche integral über der zuvor gebildeten gehärteten Harzschicht laminiert ist und mehrmaligen Wiederholens dieses Schrittes, mit oder ohne Änderung des Musters, in welchem das Licht bestrahlt wird, um einen dreidimensionalen Gegenstand zu bilden, welcher aus mehrfachen integral laminierten gehärteten Harzschichten besteht, wobei eine Harzzusammensetzung gemäß einem der Ansprüche 1-7 verwendet wird.

## Revendications

1. Composition de résine photodurcissable comprenant,

   (A) un composé organique polymérisable par voie cationique,
   (B) un photoinitiateur cationique,
   (C) un monomère éthyléniquement insaturé,
   (D) un photoinitiateur radicalaire, et
   (E) un poléther-polyol ayant en moyenne environ trois groupes hydroxyle ou plus, dans laquelle au moins 60% en poids, par rapport à la composition totale, dudit monomère éthyléniquement insaturé est un monomère polyfonctionnel ayant trois liaisons éthyléniquement insaturées ou plus dans une molécule.

2. Composition de résine photodurcissable selon la revendication 1, dans laquelle la composition a été formulée avec des composants comprenant, par rapport à la composition totale :

   30-85% en poids de composant (A)
   0,1-10% en poids de composant (B)
   5-30% en poids de composant (C)
   0,1-10% en poids de composant (D)
   5-30% en poids de composant (E).

3. Composition de résine photodurcissable selon la revendication 1 dans laquelle la composition a une viscosité à 25°C dans la gamme comprise entre 50 et 1000 mPa·s (cps).

4. Composition photodurcissable selon la revendication 1, dans laquelle le composant (A) est un composé comprenant au moins un groupe époxy.

5. Composition photodurcissable selon la revendication 1, dans laquelle le composant (C) est un composé comprenant au moins un groupe (méth)acrylate.

6. Composition photodurcissable selon la revendication 1, dans laquelle le composant (E) a en moyenne de 3 à 6 groupes hydroxyle.

7. Composition photodurcissable selon la revendication 1, dans laquelle le composant (E) a une masse moléculaire comprise entre 100 et 2000.

8. Procédé pour la fabrication d'un objet tridimensionnel comprenant les étapes consistant à former une couche de résine durcissable ayant un motif spécifié en l'irradiant sélectivement avec de la lumière, à charger la composition de résine photodurcissable équivalente à une couche pour former une autre couche mince de la composition sur cette couche de résine durcie, et à irradier sélectivement cette mince couche avec de la lumière pour former une nouvelle couche de résine durcie qui est intégralement stratifiée sur la couche de résine durcie formée précédemment et à répéter cette étape un grand nombre de fois, avec ou sans changer le motif selon lequel la lumière est projetée pour former un objet tridimensionnel constitué de couches multiples de résine durcie intégralement stratifiées, dans lequel on utilise une composition de résine selon l'une quelconque des revendications 1 à 7.

Figure 1